# EUROPEAN PATENT APPLICATION

(11) **EP 4 383 348 A1**
(43) Date of publication of application: **12.06.2024**
(21) Application number: 22852364.3
(22) Date of filing: 05.08.2022
(51) Int. Cl.: H01L 31/0216, H01L 31/06, H01L 31/18

(54) **PASSIVATION CONTACT STRUCTURE AND MANUFACTURING METHOD THEREFOR AND SOLAR CELL USING SAME**

(30) Priority: 05.08.2021 CN 202110897352
(71) Applicant: Trina Solar Co., Ltd, Changzhou, Jiangsu 213031 (CN)
(72) Inventor: PIETRO, Peter Altermatt, hangzhou, Jiangsu 213031 (CN); CHEN, Yiqi, hangzhou, Jiangsu 213031 (CN); GAO, Jifan, hangzhou, Jiangsu 213031 (CN); CHEN, Yifeng, hangzhou, Jiangsu 213031 (CN)
(74) Representative: Nederlandsch Octrooibureau
(86) International application number: PCT/CN2022/110671
(87) International publication number: WO 2023/011653

(57) **Abstract**

The present invention provides a passivation contact structure for a solar cell and a manufacturing method therefor and a solar cell using the passivation contact structure. The passivation contact structure comprises a tunnel layer; a transparent conductive film, located on the tunnel layer and in contact with the tunnel layer; a cover layer, located on the transparent conductive film; and a metal electrode, passing through the cover layer to be in contact with the transparent conductive film, the end surface of metal electrode being located in the transparent conductive film. According to the passivation contact structure for the solar cell, the manufacturing method therefor, and the solar cell using the passivation structure of the present invention, both electricity conducting and passivation effects can be achieved, and the effect of reducing the loss of light absorption can also be achieved.

## Description

### Technical Field

The present invention mainly relates to a solar cell, and in particular to a passivation contact structure and manufacturing method therefor and solar cell using same.

### Background

In conventional silicon-based solar cells, metal busbars are in direct contact with silicon to collect carriers. However, direct contact between metal and silicon will cause a large amount of additional carrier recombination, resulting in losses. In order to reduce the recombination loss during metal contact on silicon-based solar cells, the concept of "passivation contact" was proposed, the principle of which is that one type of carrier is blocked by the tunnel layer at the front end of the metal contact, so no relevant recombination occurs at the metal contact interface. At the same time, the tunnel layer is passivated, which means that the tunnel layer will not cause a large amount of carrier recombination, thereby achieving the effect of only a small amount of recombination loss during metal contact.

However, the traditional passivation contact structure generally contains amorphous silicon, and this polycrystalline layer using silicon material mostly absorbs light seriously, as a result, the existing passivation contact structure not only reduces the recombination loss caused by the direct contact between the metal busbar and silicon, but also generates parasitic light absorption loss. Therefore, on the whole, the traditional passivation contact structure placed on the front side does not have a very good effect on improving the energy conversion performance of solar cells.

### Summary

The technical problem to be solved by the present invention is to provide a passivation contact structure and manufacturing method therefor and solar cell using same, and both electricity conducting and passivation effects can be achieved, and the effect of reducing the loss of light absorption can also be achieved.

In order to solve the above technical problems, the present application provides a passivation contact structure for a solar cell, comprising: a tunnel layer; a transparent conductive film, located on the tunnel layer and in contact with the tunnel layer; a cover layer, located on the transparent conductive film; and a metal electrode, passing through the cover layer to be in contact with the transparent conductive film, and an end surface of metal electrode being located in the transparent conductive film.

In one embodiment of the present invention, the transparent conductive film is a first doping type transparent conductive film.

In one embodiment of the present invention, the passivation contact structure further comprising: a substrate; a first semiconductor layer of a first doping type located on the substrate, wherein the tunnel layer is located on the first semiconductor layer.

In one embodiment of the present invention, the first doping type is N type.

In one embodiment of the present invention, a thickness of the tunnel layer is between 0.5-3nm.

In one embodiment of the present invention, a thickness of the transparent conductive film is between 10-300nm.

In one embodiment of the present invention, a material of the transparent conductive film is one of zinc oxide.

Another aspect of the present invention also provides a solar cell, comprising the above-mentioned passivation contact structure.

Another aspect of the present invention also provides a method for manufacturing a passivation contact structure for a solar cell, comprising following steps: forming a tunnel layer; forming a transparent conductive film on the tunnel layer; forming a cover layer on the transparent conductive film; and forming a metal electrode passing through the cover layer to be in contact with the transparent conductive film, and an end surface of the metal electrode being located in the transparent conductive film.

In one embodiment of the present invention, the method further comprising forming a semiconductor layer of a first doping type on the substrate, wherein the tunnel layer is formed on the semiconductor layer.

Compared with the prior art, the present invention has the following advantages:
The present invention provides a passivation contact structure and manufacturing method therefor and solar cell using same, which adopts a method of combining a transparent conductive film with a tunnel layer, and both electricity conducting and passivation effects between metal and non-metal areas can be achieved, resulting in effectively reducing carrier recombination losses in silicon-based solar cells. At the same time, the high light transmittance of the transparent conductive film also has the effect of reducing the absorption loss of incident light, thereby improving the energy conversion efficiency of the solar cell as a whole.

### Brief Description of the Drawings

The features and performance of the present invention are further described in the following embodiments and drawings.
Fig.1 is a schematic structural view of a passivation contact structure of a solar cell according to an embodiment of the present invention;
Fig.2 is a schematic structural view of a P-type substrate solar cell using the passivation contact structure of the present invention according to an embodiment of the present invention;
Fig.3 is a schematic structural view of an N-type substrate solar cell using the passivation contact structure of the present invention according to an embodiment of the present invention; and
Fig. 4 is a schematic flowchart of a method for manufacturing a passivation contact structure for a solar cell according to an embodiment of the present invention.

### Preferred Embodiment of the Present Invention

In order to illustrate the technical solutions in the embodiments of the present application more clearly, the drawings that need to be used in the description of the embodiments will be briefly introduced below. Obviously, the drawings in the following description are only some embodiments of the present application, and for those skilled in the art, other drawings can also be obtained based on these drawings without creative effort.

As indicated in this application and claims, the terms "a", "an", "a kind of" and/or "the" do not specifically refer to the singular and may include the plural unless the context clearly indicates an exception. Generally speaking, the terms "comprising" and "including" only suggest the inclusion of clearly identified steps and elements, and these steps and elements do not constitute an exclusive list, and the method or device may also contain other steps or elements.

The relative arrangements of components and steps, numerical expressions and numerical values set forth in these embodiments do not limit the scope of the present application unless specifically stated otherwise. At the same time, it should be understood that, for the convenience of description, the sizes of the various parts shown in the drawings are not drawn according to the actual proportional relationship. Techniques, methods and devices known to those of ordinary skill in the relevant art may not be discussed in detail, but where appropriate, such techniques, methods and devices should be considered part of the authorized specification. In all embodiments shown and discussed herein, any specific values should be construed as illustrative only, and not as limiting. Therefore, other examples of the exemplary embodiment may have different values. It should be noted that like numerals and letters denote like items in the following figures, therefore, once an item is defined in one figure, it does not require further discussion in subsequent drawings.

In the description of the present application, it should be understood that orientation words such as "front, back, up, down, left, right", " landscape, portrait, vertical, horizontal" and "top, bottom" etc. indicating the orientation or positional relationship is generally based on the orientation or positional relationship shown in the drawings, only for the convenience of describing the application and simplifying the description, in the absence of a contrary statement, these orientation words do not indicate or imply that the device or element referred to must have a specific orientation or be constructed and operated in a specific orientation, and therefore cannot be construed as limiting the scope of protection of this application; the orientation words "inside and outside" refer to inside and outside relative to the outline of each part itself.

For the convenience of description, spatially relative terms may be used here, such as "on ...", "over ...", "on the upper surface of ...", "above", etc., to describe the spatial positional relationship between one device or feature and other devices or features. It will be understood that, in addition to the orientation depicted in the drawings, the spatially relative terms are intended to encompass different orientations of the device in use or operation. For example, if the device in the drawings is turned over, devices described as "on other devices or configurations " or "above other devices or configurations " would then be oriented "beneath other devices or configurations " or "under other devices or configurations ". Thus, the exemplary term "above" can encompass both an orientation of "above" and "beneath". The device may be otherwise oriented (rotated 90 degrees or at other orientations), and making a corresponding explanation for the space relative description used here.

In addition, it should be noted that the use of words such as "first" and "second" to define components is only for the convenience of distinguishing corresponding components, unless otherwise stated, the above words have no special meanings, and therefore cannot be construed as limiting the protection scope of the present application. In addition, although the terms used in this application are selected from well-known and commonly used terms, some terms mentioned in the specification of this application may be selected by the applicant according to his or her judgment, and their detailed meanings are listed in this article described in the relevant section of the description. Furthermore, it is required that this application be understood not only by the actual terms used, but also by the meaning implied by each term.

It will be understood that when an element is referred to as being "on," "connected to," "coupled to" or "in contacting with" another element, it can be directly on, connected to, coupled to, or in contact with the other element, or there may be an intervening component. In contrast, when an element is referred to as being "directly on," "directly connected to," "directly coupled to" or "directly in contacting with" another element, there are no intervening elements present. Likewise, when a first component is referred to as being "electrically contacting" or "electrically coupled to" a second component, there exists an electrical path between the first component and the second component that allows electrical current to flow. This electrical path may include capacitors, coupled inductors, and/or other components that allow current to flow, even without direct contact between conductive components.

One embodiment of the present invention proposes a passivation contact structure for a solar cell, which combines a transparent conductive film with a tunnel layer; both electricity conducting and passivation effects can be achieved, and the effect of reducing the loss of light absorption can also be achieved.

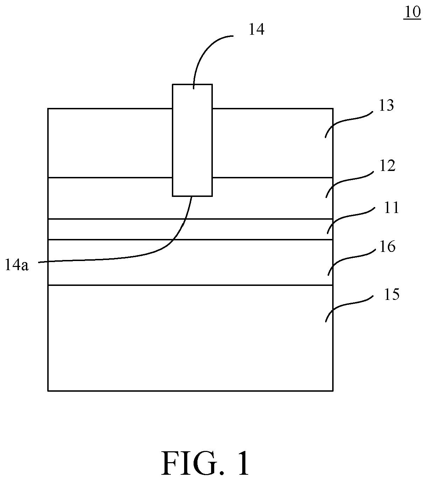

Fig.1 shows a schematic structural view of a passivation contact structure10 of a solar cell according to an embodiment of the present invention. The passivation contact structure 10 can be used on the front surface or the back surface of the solar cell. According to Fig. 1, the passivation contact structure 10 comprises a tunnel layer 11, a transparent conductive film 12, a cover layer 13 and a metal electrode 14 in sequence.

Specifically, the tunnel layer 11 can block holes from entering the transparent conductive film 12. From a material perspective, usually the tunnel layer can be silicon oxide, but the material of the tunnel layer in the present invention is not limited to this, in other embodiments of the present invention, the tunnel layer can be made of other materials. From a size perspective, in some embodiments of the present invention, the thickness of the tunnel layer 11 is between 0.5-3 nm.

Furthermore, the transparent conductive film 12 is located on the tunnel layer 11 and is in direct contact with the tunnel layer 11 without other battery hierarchical structures between them. Preferably, the transparent conductive film 12 is made of zinc oxide. However, the transparent conductive film 12 may also be made of other materials such as silicon oxide and aluminum oxide. Exemplarily, in some embodiments of the present invention, the thickness of the transparent conductive film 12 is between 10-300 nm.

Furthermore, the cover layer 13 is located on the transparent conductive film 12. The cover layer 13 can play a role in protecting the transparent conductive film 12, and is generally made of silicon nitride, aluminum oxide or other materials. For example, the cover layer 13 can protect the transparent conductive film 12 from water vapor, PID (Potential Induced Degradation) ions, physical friction, hydrogen source loss during the sintering process, and metal peeling.

Finally, the metal electrode 14 passes through the cover layer 13 and contacts the transparent conductive film 12, and the end surface 14a of the metal electrode 14 is located in the transparent conductive film 12. Wherein, the material of the metal electrode 14 may be silver, aluminum, copper, etc., and the present invention does not limit the material selection of the metal electrode. In the actual process of preparing solar cells, especially in the metal sintering process, it is ensured that the degree of metal corrosion is as follows: after the metal electrode 14 passes through the uppermost cover layer 13, it reaches a state that the metal electrode 14 is in contact with the transparent conductive film 12 but does not further reach the tunnel layer 11 or even damage it.

In some embodiments of the present invention, the transparent conductive film 12 shown in Fig. 1 is a first doping type transparent conductive film. Specifically, the first doping type may be N-type, and the transparent conductive film 12 is an N-type doping transparent conductive film. For example, when the material of the transparent conductive film 12 is zinc oxide, an appropriate amount of aluminum can be added to the slurry when manufacturing the passivation contact structure 10. This can enhance the N-type doping of the contact area between zinc oxide and the metal, making it easier for electrons to transmit from the transparent conductive film 12 to the metal electrode 14.

In general, the transparent conductive film 12 does not need to be highly doped and only needs to provide longitudinal transport of electrons. During the manufacturing process, the transparent conductive film 12 accommodates the end surface 14a of the metal electrode 14, which can effectively protect the bottom tunnel layer 11 from damage; after the battery manufacturing is completed, it can also ensure the efficient collection and transmission of electrons inside the battery. In the actual using process of the battery, by using the high light transmittance capacity (because the transparent conductive film does not require very high doping) of the transparent conductive film 12 to increase the incident rate of sunlight, it can effectively solve the impact of light absorption by amorphous silicon and polycrystalline silicon in traditional passivation structures.

Based on the above structure, in the embodiment shown in Fig. 1, the passivation contact structure 10 also comprises a substrate 15 and a first semiconductor layer 16 using the above-mentioned first doping type, and the first semiconductor layer 16 is located on the substrate 15, and the tunnel layer 11 is located on the first semiconductor layer 16. For example, the substrate 15 is made of silicon. In some embodiments of the present invention, the first semiconductor layer 16 is an N-type doping semiconductor layer. N-type doping is applied to increase lateral conduction within the substrate 15 (ie, the silicon body) and to form better contact with the transparent conductive film 12. For example, the N-type doping first semiconductor layer 16 can be realized by doping with substances such as phosphorus or gallium, which is not limited by the present invention. In embodiments of the present invention, the substrate 15 itself may be P-type doping or N-type doping. P-type doping can be achieved by doping boron or gallium, and N-type doping can be achieved by doping phosphorus or arsenic.

It can be understood that, depending on the difference of the manufacturing process, when manufacturing the first semiconductor layer 16, it can be manufactured independently on the substrate 15, or it can be doped and manufactured inside the substrate 15, and the present invention does not limit the manufacturing process. After the manufacturing is completed, an N-type doping first semiconductor layer 16 is formed on the substrate 15 as shown in Fig. 1.

The present invention adopts a structure in which a transparent conductive film (such as zinc oxide) is in direct contact with the tunnel layer, and the two can be used in combination to together achieve a passivation effect. During the actual manufacturing of solar cells, especially during the metal sintering process, the transparent conductive film can effectively protect the tunnel layer in direct contact with it from damage, and after the cell manufacturing is completed, it can ensure efficient collection and transmission of electrons.

In addition, the structure in which the transparent conductive film is combined with the tunnel layer avoids serious adverse consequences of light absorption by the polysilicon layer in the existing passivation structure, utilizing the high light transmittance of the transparent conductive film, and the passivation contact structure of the present invention can effectively reduce light absorption loss while providing a passivation contact effect. For example, an ellipsometer is applied to compare aluminum-doped ZnO (that is, a transparent conductive film used in a passivation contact structure of a solar cell according to an embodiment of the present invention) with polysilicon that provides passivation contact for traditional solar cells, at the same wavelength of 632nm, the extinction coefficient of aluminum-doped ZnO is about 0.017, and that of polysilicon is 0.252.It can be seen from this that the use of the passivation contact structure of the present invention can significantly reduce light absorption loss, improving the energy conversion efficiency of solar cells, and optimizing the performance of solar cells.

Based on the above passivation contact structure of the solar cell, an embodiment of the present invention also provides a solar cell comprising the above passivation contact structure. Compared with traditional passivation contact structures solar cells, solar cells with the above passivation contact structure avoid the adverse effects of light absorption by the polysilicon layer and have better energy conversion effects.

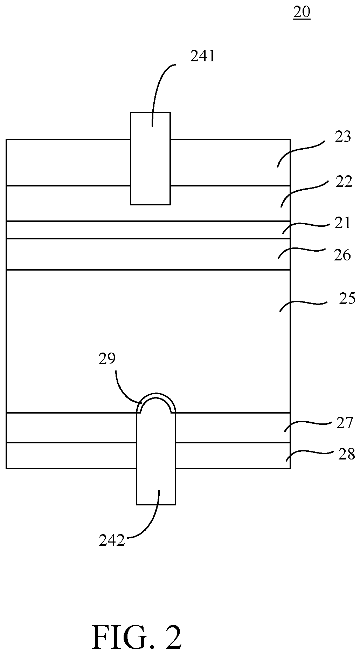

Fig. 2 shows the structure of a TOPerc (the backside structure of a passivation emitter and rear cell (PERC) combined with the frontside structure of a TOPCon cell) solar cell 20 using the passivation contact structure of the invention according to an embodiment of the present invention. The solar cell 20 in this embodiment is a P-type substrate cell, but the present invention is not limited to this structure type. As can be seen in Fig. 2, the upper half of the solar cell 20 (that is, the positive electrode part) adopts a passivation contact structure as shown in Fig. 1, which specifically comprises a tunnel layer 21, a transparent conductive film 22, and a cover layer 23, front metal electrode 241, P-type substrate 25 and N-type doping first semiconductor layer 26. For example, in an embodiment of the present invention, the P-type substrate 25 is a P-type silicon substrate, the first semiconductor layer 26 is N-type doping (for example, phosphorus doping), and the tunnel layer 21 is silicon oxide, the transparent conductive film 22 is made of aluminum-doping zinc oxide and the cover layer 23 is made of silicon nitride, but the solar cell of the present invention is not limited to such material selection.

On this basis, on the back side of the solar cell 20, there is also a passivation layer 27, a passivation anti-reflection film 28 and a metal electrode 242 on the back side under the P-type substrate 25. The material of the passivation layer 27 is, for example, aluminum oxide, and the material of the passivation anti-reflection film 28 is, for example, silicon nitride. As for the metal electrode 242 on the back, its end surface located in the P-type substrate 25 also has an aluminum back field 29. These structures are conventional PERC battery structures and will not be elaborated here since they are not the focus of the present invention.

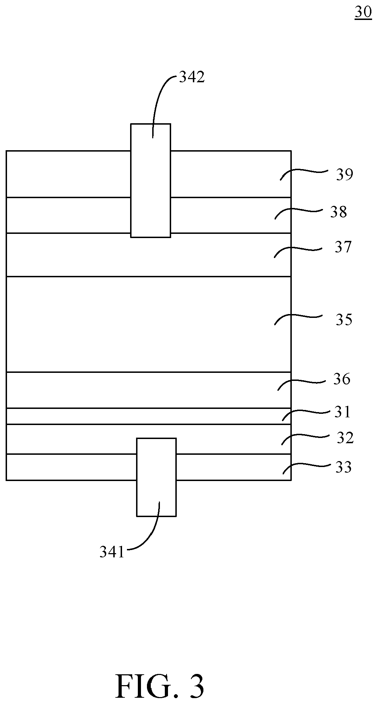

Similarly, as shown in Fig. 3, it is a schematic structural view of an N-type solar cell using the passivation contact structure of the present invention according to an embodiment of the present invention. The back side of the solar cell 30 has the passivation contact structure described above. Specifically, the solar cell 30 has a tunnel layer 31, a transparent conductive film 32, a cover layer 33, a metal electrode 341 on the back, an N-type substrate 35 and an N-type doping first semiconductor layer 36. On this basis, the front side of the solar cell 30 also has a front metal electrode 342, a passivation anti-reflection film 39, a passivation layer 38, and an emitter 37. For example, the passivation anti-reflection film 39 is, for example, silicon nitride; the passivation layer is, for example, aluminum oxide; and the emitter 37 is, for example, a boron diffused emitter. For example, in an embodiment of the present invention, the N-type substrate 35 is an N-type silicon substrate, the first semiconductor layer 36 is N-type doping (for example, phosphorus doping), and the tunnel layer 31 is silicon oxide, the transparent conductive film 32 is aluminum-doping zinc oxide and the cover layer 33 is silicon nitride. Similarly, the solar cell of the present invention is not limited to such material selection.

The above-mentioned solar cell applies the above-mentioned passivation contact structure of the present invention on its front or back side, in which the transparent conductive film has high light transmittance capacity and is used in combination with the tunnel layer; on the basis of providing passivation contact effect, compared with traditional solar cells that use polysilicon as a passivation layer, the above-mentioned passivation contact structure also have the effect of reducing light absorption loss. Further, the present invention is not limited to the embodiments shown in Fig.2 and Fig.3. For example, in some embodiments of the present invention, the above-mentioned passivation contact structure can be used on both the front and back sides of the solar cell, thus providing better passivation contact effects in different application scenarios while effectively reducing light absorption loss.

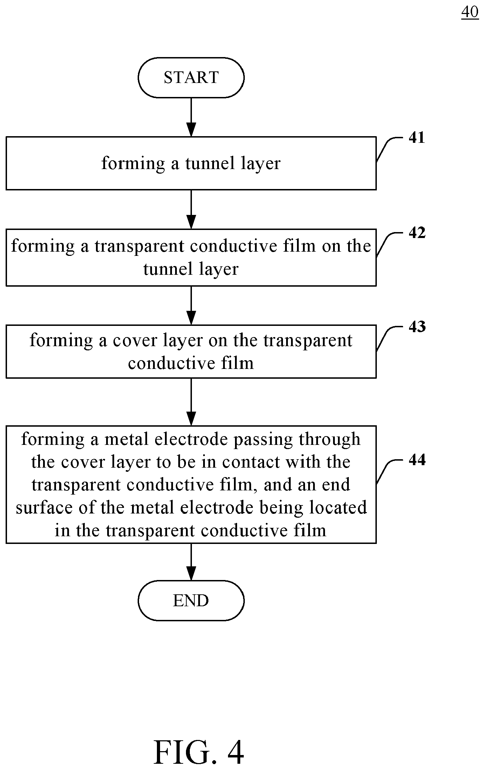

Another embodiment of the present invention also provides a method for manufacturing the above-mentioned passivation contact structure for a solar cell. As shown in Fig.4, the method 40 comprises the following steps.

Step 41 is forming a tunnel layer. For example, the tunnel layer can be deposited by a thermal oxygen reaction. In an embodiment of the present invention, the deposition temperature is 750°C, and the thickness of the tunnel layer finally formed is 1.5 nm.

Step 42 is forming a transparent conductive film on the tunnel layer. In one embodiment of the present invention, the transparent conductive film is formed by using the ALD method (atomic layer deposition) to deposit a transparent conductive film ZnO on one side of the tunnel layer, the deposition temperature is 200°C, and the thickness of the transparent conductive film finally formed is 60nm.

Step 43 is forming a cover layer on the transparent conductive film. Specifically, in some embodiments of the present invention, the step of preparing the cover layer in step 43 may use a tubular PECVD (Plasma Enhanced Chemical Vapor Deposition) method to prepare SiNx as the cover layer.

Step 44 is forming a metal electrode passing through the cover layer and to be in contact with the transparent conductive film, and an end surface of the metal electrode being located in the transparent conductive film.

Based on the above steps, in some embodiments of the present invention, the method for manufacturing a passivation contact structure for a solar cell further comprises forming a first doping type semiconductor layer on the substrate, and the tunnel layer formed in step 41 will be formed on the semiconductor layer, and the first doping type may be N-type. For other details and technical effects of the manufacturing method of the passivation contact structure for solar cells of the present invention, please refer to the above description of the passivation contact structure and the solar cell with the passivation contact structure of the present invention, which will not be described again in this part.

Fig. 4 in this application uses a flow chart to illustrate the operations performed by the system according to the embodiment of this application. It should be understood that the preceding or following operations are not necessarily performed in exact order. Instead, the various steps can be processed in reverse order or simultaneously. At the same time, other operations may be added to these processes, or a step or steps may be removed from these processes.

With reference to Fig.2, in one embodiment, the manufacturing method of a TOPerc solar cell (taking a P-type substrate cell as an example) with the above passivation contact structure is as follows:
(1) Selecting P-type silicon substrate 25 and performing texturing treatment on the surface.
(2) Cleaning the silicon wafer processed in step (1) and put it into a diffusion furnace, the silicon wafer is diffused with phosphorus to form an N-type doping first semiconductor layer 26, and at the same time forming a P-N junction and phosphosilicate glass (PSG).
(3) Performing hydrofluoric acid post-cleaning on one side of the silicon wafer, and using a single-side etching cleaning machine to remove the PSG on the back.
(4) Polishing the back of the silicon wafer, at this time, the front side is protected by PSG, so it will not be affected; then cleaning the silicon wafer with concentrated sulfuric acid, hydrofluoric acid, ammonia, hydrofluoric acid, hydrochloric acid, and hydrofluoric acid in sequence and removing the front PSG film.
(5) Putting the silicon wafer into a tube furnace for thermal oxygen reaction, and depositing silicon oxide as the tunnel layer 21, the deposition temperature is 750°C, and the film thickness is about 1.5nm.
(6) Using the (atomic layer deposition) ALD method to deposit an undoped ZnO or ZnO: Al layer as the transparent oxide film 22 on one side of the silicon wafer tunnel layer 21, the deposition temperature is 200°C and the thickness is 60nm.
(7) Depositing a back passivation film, using the tubular PECVD method, to sequentially deposit an aluminum oxide/silicon nitride layer on the back of the silicon wafer as the passivation layer 27 and the passivation anti-reflection film 28. After that, the cover layer 23 is deposited on the front surface, that is, the silicon nitride layer is sequentially prepared using the tubular PECVD method.
(8) Using a laser to open the back passivation layer 27 and the passivation anti-reflection film 28.
(9) Printing the front and back metal electrodes 241, 242 and finger and sinter them.

With reference to Fig.3, in one embodiment, the manufacturing method of an N-type substrate battery with the above passivation contact structure as an example is as follows:
(1) Selecting N-type silicon substrate 35 and performing texturing treatment on the surface.
(2) Cleaning the silicon substrate 35 processed in step (1) and putting it into a diffusion furnace, boron is diffused on the silicon wafer to form a P+ doping emitter 37 and borosilicate glass (BSG) is formed at the same time.
(3) Cleaning one side of the silicon wafer with HF acid and use this side as the back side, using a single-sided etching cleaning machine to remove the BSG on the back side and cleaning the silicon wafer.
(4) Polishing the back of the silicon wafer and performing secondary texturing, at this time, the front side is protected by BSG, so it will not be affected, then washing the silicon wafer.
(5) Placing the cleaned silicon wafer into a tubular diffusion furnace, and performing phosphorus diffusion on the back surface to form an n++ doping layer 36. The silicon wafer is then cleaned with HF acid to remove the PSG on the back and the PSG and BSG on the front.
(5) Putting the silicon wafer into a tube furnace for thermal oxygen reaction, and depositing silicon oxide as the tunnel layer 31, the deposition temperature is 750°C, and the film thickness is about 1.5nm.
(6) Using the (atomic layer deposition) ALD method or PECVD method to deposit undoped ZnO or doping ZnO: Al layer as the transparent oxide film 32 on the tunnel layer 31, the deposition temperature is 200°C for ALD or 350°C for PECVD, the thickness is 100nm.
(7) Depositing the back cover layer 33, that is, using the tube PECVD method to deposit a silicon nitride layer on the back of the silicon wafer. Then, the passivation layer 38 and the passivation anti-reflection layer 39 are deposited on the front surface, the tube PECVD method is used to sequentially prepare aluminum oxide/silicon nitride layers, and the ALD method can also be used to deposit AlOx.
(8) Printing the front and back metal electrodes 341, 342 and finger and sinter them.

The basic concepts have been described above, obviously, for those skilled in the art, the above disclosure of the invention is only an example, and does not constitute a limitation to the present application. Although not expressly stated here, various modifications, improvements and amendments to this application may be made by those skilled in the art. Such modifications, improvements, and amendments are suggested in this application, so such modifications, improvements, and amendments still belong to the spirit and scope of the exemplary embodiments of this application.

Meanwhile, the present application uses specific words to describe the embodiments of the present application. For example, "one embodiment", "an embodiment", and/or "some embodiments" refer to a certain feature, structure or characteristic related to at least one embodiment of the present application. Therefore, it should be emphasized and noted that two or more references to "one embodiment" or "an embodiment" or "an alternative embodiment" in different places in this specification do not necessarily refer to the same embodiment. In addition, certain features, structures or characteristics of one or more embodiments of the present application may be properly combined.

In the same way, it should be noted that in order to simplify the expression disclosed in the present application and help the understanding of one or more embodiments of the invention, in the foregoing description of the embodiments of the present application, sometimes multiple features are combined into one embodiment, drawings or descriptions thereof. However, this method of disclosure does not imply that the subject matter of the application requires more features than are recited in the claims. Indeed, embodiment features are less than all features of a single foregoing disclosed embodiment.

In some embodiments, numbers describing the quantity of components and attributes are used, it should be understood that such numbers used in the description of the embodiments use the modifiers "about", "approximately" or "substantially" in some examples. Unless otherwise stated, "about", "approximately" or "substantially" indicates that the stated figure allows for a variation of ±20%. Accordingly, in some embodiments, the numerical parameters used in the specification and claims are approximations that can vary depending upon the desired characteristics of individual embodiments. In some embodiments, numerical parameters should take into account the specified significant digits and adopt the general digit reservation method. Although the numerical ranges and parameters used in some embodiments of the present application to confirm the breadth of the scope are approximate values, in specific embodiments, such numerical values are set as precisely as practicable.

Although the present application has been described with reference to the current specific embodiments, those of ordinary skill in the art should recognize that the above embodiments are only used to illustrate the present application, and various equivalent changes or substitutions can also be made without departing from the spirit of the present application, therefore, as long as the changes and modifications to the above-mentioned embodiments are within the spirit of the present application, they will all fall within the scope of the claims of the present application.

## Claims

1. A passivation contact structure for a solar cell, comprising:
a tunnel layer;
a transparent conductive film, located on the tunnel layer and in contact with the tunnel layer;
a cover layer, located on the transparent conductive film; and
a metal electrode, passing through the cover layer to be in contact with the transparent conductive film, and an end surface of metal electrode being located in the transparent conductive film.

2. The passivation contact structure according to claim 1, **characterized in that**, the transparent conductive film is a first doping type transparent conductive film.

3. The passivation contact structure according to claim 1, **characterized by** further comprising:
a substrate;
a first semiconductor layer of a first doping type located on the substrate, wherein the tunnel layer is located on the first semiconductor layer.

4. The passivation contact structure according to claim 2 or 3, **characterized in that**, the first doping type is N type.

5. The passivation contact structure according to claim 1, **characterized in that**, a thickness of the tunnel layer is between 0.5-3nm.

6. The passivation contact structure according to claim 1, **characterized in that**, a thickness of the transparent conductive film is between 10-300nm.

7. The passivation contact structure according to claim 1, **characterized in that**, a material of the transparent conductive film is one of zinc oxide, tin oxide, and titanium oxide.

8. A solar cell, comprising the passivation contact structure according to any one of claims 1-7.

9. A method for manufacturing a passivation contact structure for a solar cell, comprising following steps:
forming a tunnel layer;
forming a transparent conductive film on the tunnel layer;
forming a cover layer on the transparent conductive film; and
forming a metal electrode passing through the cover layer to be in contact with the transparent conductive film, and an end surface of the metal electrode being located in the transparent conductive film.

10. The method according to claim 9, **characterized by** further comprising:
forming a semiconductor layer of a first doping type on the substrate, wherein the tunnel layer is formed on the semiconductor layer.
